(19) **Europäisches Patentamt / European Patent Office / Office européen des brevets**

(11) **EP 3 542 406 B1**

(12) **FASCICULE DE BREVET EUROPEEN**

(45) Date de publication et mention de la délivrance du brevet:
**02.04.2025 Bulletin 2025/14**

(21) Numéro de dépôt: **17811633.1**

(22) Date de dépôt: **16.11.2017**

(51) Classification Internationale des Brevets (IPC):
**H10N 70/00** *(2023.01)*     **H10N 70/20** *(2023.01)*

(52) Classification Coopérative des Brevets (CPC):
**H10N 70/24; H10N 70/043; H10N 70/245; H10N 70/826; H10N 70/828; H10N 70/8833**

(86) Numéro de dépôt international:
**PCT/FR2017/053136**

(87) Numéro de publication internationale:
**WO 2018/091828 (24.05.2018 Gazette 2018/21)**

(54) **PROCÉDÉ DE FABRICATION D'UNE MÉMOIRE RÉSISTIVE**

VERFAHREN ZUR HERSTELLUNG EINES RESISTIVEN SPEICHERS

PROCESS FOR MANUFACTURING A RESISTIVE MEMORY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.11.2016 FR 1661230**

(43) Date de publication de la demande:
**25.09.2019 Bulletin 2019/39**

(73) Titulaire: **Commissariat à l'Energie Atomique et aux Energies Alternatives**
**75015 Paris (FR)**

(72) Inventeurs:
• **CHARPIN-NICOLLE, Christelle**
**38120 Fontanil-Cornillon (FR)**
• **BIASSE, Béatrice**
**38410 Saint Martin d'Uriage (FR)**

(74) Mandataire: **Cabinet Camus Lebkiri**
**25 rue de Maubeuge**
**75009 Paris (FR)**

(56) Documents cités:
**US-A1- 2010 243 983     US-A1- 2015 041 750**
**US-B1- 6 972 429**

**Description**

**DOMAINE TECHNIQUE**

La présente invention est relative au domaine des mémoires résistives à accès aléatoire RRAM (pour « Resistive Random Access Memories » en anglais). L'invention concerne plus particulièrement un procédé de fabrication d'une mémoire résistive.

**ÉTAT DE LA TECHNIQUE**

Les mémoires résistives, en particulier les mémoires résistives à base d'oxyde (OxRAM, pour « Oxyde-based Random Access Memories »), sont des mémoires non-volatiles ayant pour but de remplacer les mémoires de type Flash. En plus d'une forte densité d'intégration, elles présentent une vitesse de fonctionnement élevée, une grande endurance et une bonne compatibilité avec les procédés de fabrication utilisés actuellement dans l'industrie microélectrique, en particulier avec le procédé de fin de ligne (BEOL, pour « Back-End Of Line » en anglais) de la technologie CMOS.

Les mémoires résistives OxRAM comprennent une multitude de cellules mémoire, appelées également points mémoire. Chaque cellule de mémoire OxRAM est constituée d'une capacité M-I-M (Métal-Isolant-Métal) comprenant un matériau actif de résistance électrique variable, en général un oxyde de métal de transition, disposé entre deux électrodes métalliques. L'oxyde commute, de manière réversible, entre deux états de résistance, qui correspondent aux valeurs logiques « 0 » et « 1 » utilisées pour coder un bit d'information. Dans certains cas, plus de deux états de résistance peuvent être générés, ce qui permet de stocker plusieurs bits d'informations dans une même cellule mémoire.

L'information est écrite dans la cellule mémoire en basculant l'oxyde d'un état fortement résistif « HRS » (« High Resistance State » en anglais), appelé également état « OFF », à un état faiblement résistif « LRS » (« Low Resistance State »), ou état « ON ». À l'inverse, pour effacer l'information de la cellule mémoire, l'oxyde est basculé de l'état « LRS » vers l'état « HRS ». L'opération d'écriture d'une cellule de mémoire résistive OxRAM est appelé « SET » tandis que l'opération d'effacement est appelé « RESET ».

Le changement de résistance de l'oxyde est gouverné par la formation et la rupture d'un filament conducteur de section nanométrique entre les deux électrodes. En l'état actuel des connaissances, ce filament semble être dû à l'accumulation de lacunes d'oxygène (au moins pour la famille des oxydes à base de métaux de transition), qui peut être accompagnée d'un mouvement d'ions métalliques.

Un inconvénient des mémoires résistives OxRAM est la grande variabilité de la résistance électrique d'une cellule mémoire à l'état « OFF » au cours des cycles d'écriture et d'effacement. Par exemple, la résistance à l'état « OFF » entre plusieurs opérations d'effacement successives peut varier de plus d'un ordre de grandeur. Bien que moins marqué, le phénomène est également observable pour l'état « ON ». Cette variabilité s'observe non seulement au fil des cycles d'endurance sur une même cellule, mais également de cellule à cellule.

Ce problème de variabilité de la résistance électrique est aujourd'hui un réel frein à l'industrialisation, car il induit une diminution de la fenêtre de programmation (différence de résistance entre les états « HRS »/« OFF » et « LRS »/« ON ») et par conséquent un risque de perdre l'information stockée dans la cellule mémoire. Ce souci demeure malgré de nombreux efforts réalisés dans les domaines de la fabrication et de la programmation des mémoires résistives OxRAM.

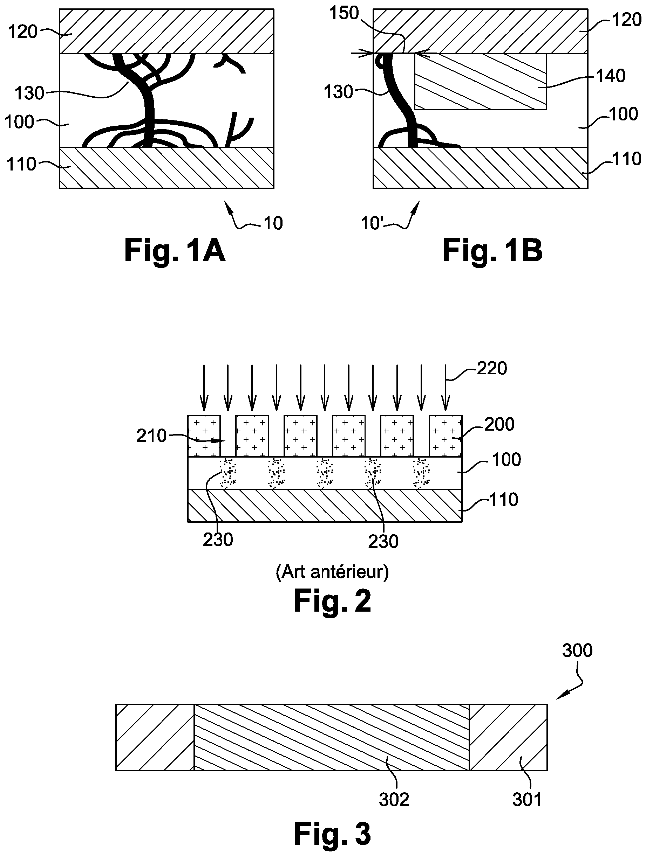

La figure 1A représente schématiquement une cellule mémoire OxRAM 10 selon l'art antérieur. Cette cellule 10 comprend une couche d'oxyde métallique 100 disposée entre une première électrode 110 et une deuxième électrode 120. Un filament conducteur 130 continu entre les électrodes 110-120 est formé à travers la couche d'oxyde 100 lors de l'écriture de la cellule mémoire.

D'après plusieurs études, une solution pour réduire la variabilité des performances électriques consisterait à réduire les dimensions de la cellule mémoire. En particulier, le document [« Conductive Filament Control in Highly Scalable Unipolar Resistive Switching Devices for Low-Power and High-density Next Generation Memory », Ryoo Kyung-Chang et al., IEDM 2013] a montré qu'une réduction de la surface de contact entre l'une des électrodes 110-120 et la couche d'oxyde 100 permettait de localiser la formation (et la rupture) du filament conducteur 130 et de réduire les problèmes de dispersion des cellules.

La figure 1B montre la cellule mémoire OxRAM 10' proposée par Ryoo et al. dans l'article susmentionné. Un plot électriquement isolant 140 occupe une partie centrale de la couche d'oxyde 100 en contact avec la deuxième électrode 120, ce qui a pour effet de limiter la surface de contact entre la deuxième électrode 120 et la couche d'oxyde 100 à une zone 150 située à la périphérie du plot isolant 140. Avec une telle configuration de cellule, il apparaît que le filament conducteur 130 est dirigé vers la zone périphérique 150, et par conséquent confiné à un bord de la cellule.

Le procédé de fabrication de cette cellule mémoire 10' est toutefois complexe à mettre en œuvre. En effet, il fait appel à de nombreuses étapes de lithographie, de dépôts et de planarisation. De façon générale, pour réduire la surface de contact, des techniques de lithographie avancées, telles que la lithographie à faisceau d'électrons (e-beam), sont nécessaires. Or ces techniques sont lourdes et coûteuses à mettre en œuvre. Par ailleurs, la reprise de contact électrique de la deuxième électrode 120, de faibles dimensions est difficile à obtenir. Les contraintes pour l'industrialisation d'un tel procédé de fabrication sont donc nombreuses.

Le brevet US8872268 (Miller et al.) décrit une autre technique pour localiser la formation du filament conducteur dans la couche d'oxyde métallique 100 d'une cellule mémoire OxRAM. Un masque 200 comprenant plusieurs évidements 210 est formé sur la couche d'oxyde 100, afin de délimiter dans la couche d'oxyde des zones protégées et des zones exposées. Puis, la couche d'oxyde métallique 100 recouverte du masque 200 est soumise à une implantation ionique 220. Les ions sont implantés uniquement dans les zones exposées de la couche d'oxyde 100, formant ainsi plusieurs chemins de défauts localisés 230 dans ces mêmes zones. Les défauts peuvent être des atomes métalliques ou d'oxygène en position interstitielle, des atomes métalliques en position substitutionnelle ou des lacunes d'oxygène. Lors du fonctionnement ultérieur de la cellule mémoire, le filament conducteur emprunte l'un des chemins de défauts localisés formés dans la couche d'oxyde 100.

En réalisant ainsi des chemins de conduction préférentiels pour le filament conducteur, les changements de résistance provoqués lors des opérations de SET et de RESET peuvent être obtenus avec des tensions plus faibles. Une telle localisation du filament conducteur a également pour effet d'augmenter le rapport des courants entre l'état « ON » et l'état « OFF ».

La formation du masque 200, l'implantation ionique 220 et le retrait du masque 200 avant le dépôt de l'électrode supérieure constituent toutefois des étapes supplémentaires par rapport au procédé classique de fabrication des mémoires OxRAM. Par ailleurs, pour confiner le filament dans une zone restreinte, le masque 200 doit présenter de bonnes caractéristiques de résolution, ce qui nécessite à nouveau de faire appel aux techniques de lithographie avancées. La solution proposée par le brevet US8872268 ne permet donc pas d'améliorer les performances de la cellule à moindre coût.

Par ailleurs, le document US2015/041750 décrit un dispositif mémoire résistif dans lequel chaque cellule mémoire est capable de stocker plusieurs bits d'information. Le procédé de fabrication de ce dispositif mémoire résistif comprend :

- la formation d'électrodes inférieures sur un substrat ;
- le dépôt d'une couche de matériau actif sur les électrodes inférieures et le substrat ;
- le dépôt d'une couche de métal sur la couche de matériau actif ;
- la gravure de la couche de métal et de la couche de matériau actif entre les électrodes inférieures, de façon à délimiter les différentes cellules mémoire ;
- l'implantation ionique d'un élément dopant dans une portion de la couche de matériau actif des cellules mémoire, le faisceau d'ions étant incliné d'un angle compris entre 20° et 60°.

## RÉSUMÉ DE L'INVENTION

Il existe donc un besoin de prévoir un procédé de fabrication de mémoire résistive simple et économique permettant de confiner la formation du filament conducteur à une portion seulement de la couche en matériau actif de résistance électrique variable, dans le but d'améliorer les performances de la mémoire.

Selon l'invention, on tend à satisfaire ce besoin en prévoyant un procédé de fabrication comprenant les étapes suivantes :

- déposer une couche en un matériau actif de résistance électrique variable sur un substrat contenant une première électrode, dite électrode inférieure ;
- déposer une couche électriquement conductrice sur la couche de matériau actif ;
- graver la couche électriquement conductrice de façon à délimiter une deuxième électrode, dite électrode supérieure, en regard de l'électrode inférieure ;
- exposer au moins un flanc de l'électrode supérieure à un faisceau d'ions incliné par rapport à la normale au substrat d'un angle compris entre 20° et 65°, de façon à implanter les ions dans une portion de la couche de matériau actif adjacente audit flanc et située sous l'électrode supérieure, les conditions d'implantation des ions étant choisies de façon à créer des défauts dans la structure du matériau actif et à obtenir une largeur moyenne d'implantation comprise entre 5 nm et 10 nm et les ions étant implantés à une dose comprise entre $10^{13}$ atomes.cm$^{-2}$ et $10^{16}$ atomes.cm$^{-2}$.

L'exposition du (ou des) flanc(s) de l'électrode supérieure à un faisceau d'ions incliné permet de limiter la formation des défauts à une portion de la couche de matériau actif située à proximité immédiate du flanc exposé. En effet, le reste de la couche de matériau actif est protégée par l'électrode supérieure qui, par effet d'ombrage, fait obstacle à l'implantation des ions.

Contrairement au procédé de l'art antérieur, le procédé de fabrication selon l'invention ne requiert aucune étape de photolithographie avec des spécifications strictes en termes de dimensions pour délimiter la zone de défauts dans la couche de matériau actif. Par ailleurs, la seule étape additionnelle par rapport au procédé de fabrication classique des mémoires résistives est l'étape d'implantation ionique. Le coût de fabrication d'une mémoire résistive avec le procédé de l'invention est donc plus faible qu'avec les procédés de l'art antérieur. Enfin, l'implantation ionique est une technique largement répandue et parfaitement maîtrisée dans l'industrie microélectrique, notamment pour le dopage des matériaux semi-conducteurs. Elle ne pose donc aucune difficulté pour la mise en œuvre du procédé de fabrication selon l'invention à l'échelle industrielle.

L'angle d'inclinaison par rapport à la normale du faisceau d'ions implantés est, dans ce procédé de fabrication de mémoire résistive, bien supérieur à celui rencontré habituellement dans l'industrie microélectrique. En effet, pour le dopage de couches semi-conductrices, on incline généralement le faisceau d'ions de quelques degrés (en général 7°) pour éviter les effets de canalisation dans les matériaux cristallins. Ici, cet angle ne permettrait pas de définir une zone de défauts suffisamment grande pour la formation du filament.

De préférence, le faisceau d'ions est incliné par rapport à la normale au substrat d'un angle compris entre 40° et 50°.

Dans un mode de mise en œuvre préférentiel du procédé, la couche de matériau actif sert de couche d'arrêt lors de la gravure de la couche électriquement conductrice. Ainsi, seule la couche électriquement conductrice est gravée et l'électrode inférieure est protégée, au moins partiellement, de l'implantation ionique par la couche de matériau actif.

Avantageusement, les ions sont implantés avec une énergie telle que la profondeur moyenne de pénétration des ions se situe à l'intérieur de la couche de matériau actif. Avantageusement, le procédé de fabrication comprend en outre une étape de dépôt d'un matériau de protection sur la couche électriquement conductrice avant l'étape de gravure de la couche électriquement conductrice (pour délimiter l'électrode supérieure). Ce matériau protecteur empêche que l'implantation ionique ne dégrade la face supérieure de la deuxième électrode et ne diminue ses performances électriques.

Le procédé selon l'invention peut également présenter une ou plusieurs des caractéristiques ci-dessous, considérées individuellement ou selon toutes les combinaisons techniquement possibles :

- les ions implantés sont des ions métalliques, des ions oxygène, des ions halogène, des ions silicium ou des ions argon ;
- la couche électriquement conductrice est gravée de façon à délimiter au moins deux électrodes supérieures et l'angle d'inclinaison $\alpha$ du faisceau d'ions est choisi de telle sorte que :

$$\tan \alpha \leq \frac{S}{h}$$

S étant la distance minimale séparant deux électrodes et h étant l'épaisseur de la couche électriquement conductrice ; et
- le matériau actif est un oxyde de métal de transition.

**BRÈVE DESCRIPTION DES FIGURES**

D'autres caractéristiques et avantages de l'invention ressortiront clairement de la description qui en est donnée ci-dessous, à titre indicatif et nullement limitatif, en référence aux figures annexées, parmi lesquelles :

- les figures 1A et 1B, précédemment décrites, représentent deux types de cellule mémoire résistive OxRAM selon l'art antérieur ;
- la figure 2, précédemment décrite, illustre l'étape d'implantation ionique d'un procédé de fabrication de mémoire OxRAM selon l'art antérieur ;
- la figure 3 représente en coupe transversale un substrat servant de point de départ au procédé de fabrication de mémoire résistive selon l'invention ;
- les figures 4A à 4C représentent schématiquement des étapes S1 à S3 d'un procédé de fabrication de mémoire résistive, d'après un mode de mise en œuvre préférentiel de l'invention ;
- la figure 5 est une vue en coupe transversale de la cellule de mémoire résistive à l'issue du procédé de fabrication des figures 4A à 4C ; et
- la figure 6 illustre deux cellules de mémoire résistive espacées d'une distance suffisante pour réaliser l'implantation ionique de la figure 4C dans chacune des cellules mémoire.

Pour plus de clarté, les éléments identiques ou similaires sont repérés par des signes de références identiques sur l'ensemble des figures.

**DESCRIPTION DÉTAILLÉE D'AU MOINS UN MODE DE RÉALISATION**

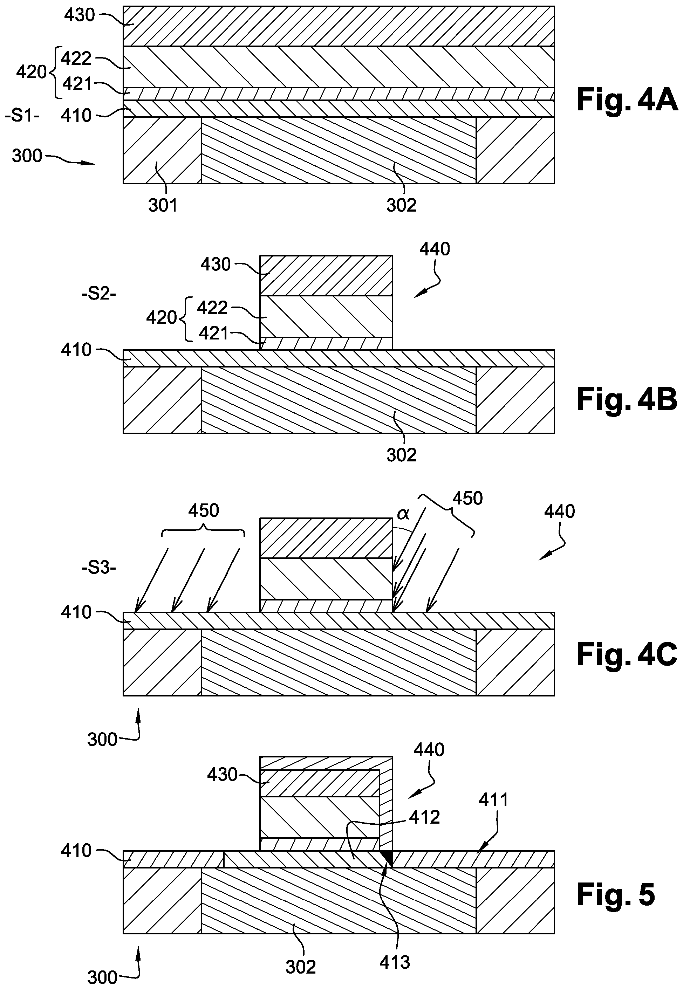

Un mode de mise en œuvre préférentiel du procédé de fabrication de mémoire résistive selon l'invention est décrit ci-dessous en référence aux figures 3, 4A à 4C et 5. La figure 3 montre un substrat 300 pouvant servir de point de départ au procédé de fabrication. Les figures 4A à 4C représentent différentes étapes S1 à S3 du procédé de fabrication. Enfin, la figure 5 illustre la mémoire résistive obtenue à l'issue du procédé de fabrication des figures 4A à 4C.

La mémoire résistive peut comporter une multitude de cellules mémoire identiques, par exemple organisées en lignes et en colonnes. Chaque cellule mémoire comprend une première électrode appelée électrode inférieure, une deuxième électrode dite électrode supérieure et une couche d'oxyde disposée entre les première et deuxième électrodes. La couche d'oxyde peut être commune à plusieurs cellules mémoire, à l'instar de l'une ou l'autre des électrodes inférieure et supérieure. Par exemple, dans une matrice de cellules mémoire à points de croisement (« cross-point » en anglais), les cellules mémoire d'une même rangée partagent la même électrode inférieure (formée par la ligne de bit) et les cellules mémoire d'une même colonne partage la même électrode (formée par la ligne de mot).

Le substrat 300 comporte avantageusement un circuit CMOS capable d'adresser chaque cellule mémoire et/ou de lire la donnée enregistrée dans la cellule mémoire, soit la valeur de résistance électrique de la cellule. Ce circuit comporte par exemple des transistors reliés électriquement aux cellules mémoire par un ou plusieurs niveaux d'interconnexion. Sur la figure 3, on a représenté en coupe transversale uniquement le dernier niveau d'interconnexion avant les cellules mémoire. Il est formé d'une couche en matériau diélectrique 301 (par exemple en SiO$_2$ ou SiN) traversée par des motifs d'interconnexion 302, de préférence en métal (cuivre, aluminium, alliages métalliques...) ou en nitrure de titane. Ces motifs d'interconnexion 302 sont par exemple des via conducteurs ou des lignes conductrices et permettent de relier électriquement les cellules mémoire au circuit CMOS sous-jacent.

Pour des raisons de clarté, la mémoire résistive représentée à divers stades de sa fabrication sur les figures 3 à 5 ne comprend qu'une seule cellule mémoire. Par conséquent, le substrat 300 de la figure 3 ne compte qu'un seul motif d'interconnexion 302.

Dans ce mode de mise en œuvre préférentiel, le motif d'interconnexion 302 du substrat 300 constitue l'électrode inférieure de la cellule mémoire. De façon alternative, un plot métallique (entouré d'une autre couche diélectrique) peut être formé sur le motif d'interconnexion 302 et constituer l'électrode inférieure de la cellule.

À l'étape S1 de la figure 4A, le substrat 300 est successivement recouvert d'une couche 410 en un matériau actif de résistance électrique variable et d'une couche électriquement conductrice 420 destinée à former l'électrode supérieure de la cellule mémoire. Le matériau de résistance électrique variable de la couche 410 est un matériau diélectrique pouvant basculer d'un état fortement résistif (« HRS ») à un état faiblement résistif (« LRS »).

La mémoire résistive fabriquée peut être de type OxRAM (« Oxyde-based Random Access Memories »), CBRAM (« Conductive Bridge Random Access Memory ») ou HRAM (« Hybrid Random Access Memory »), selon la nature du matériau actif utilisé et de l'électrode supérieure.

De préférence, le matériau actif est un oxyde, et plus préférentiellement un oxyde de métal de transition, par exemple l'oxyde d'hafnium (HfO$_2$), l'oxyde de titane (TiO$_2$), l'oxyde de tantale (Ta$_2$O$_5$), l'oxyde de Nickel (NiO) ou l'oxyde de zinc (ZnO). La mémoire est alors de type OxRAM. La couche diélectrique 410 peut aussi être composée de plusieurs sous-couches d'oxyde superposées (par exemple de type Al$_2$O$_3$/HfO$_2$).

La couche électriquement conductrice 420 est formée d'un ou plusieurs matériaux conducteurs superposés, de préférence choisi(s) parmi des métaux (platine, titane, tantale, hafnium, zirconium), le nitrure de titane (TiN), le nitrure de tantale (TaN), le polysilicium dopé et les siliciures métalliques. Dans l'exemple représenté sur la figure 3, la couche conductrice 420 est constituée d'un empilement d'une sous-couche en titane 421 et d'une sous-couche en nitrure de titane 422.

L'épaisseur de la couche de matériau actif 410 est comprise entre 1 nm et 20 nm, tandis que l'épaisseur de la couche conductrice 420 est comprise entre 5 nm et 200 nm.

De façon avantageuse, la couche conductrice 420 est recouverte d'une couche de protection 430, par exemple en SiO$_2$ ou en SiN. Cette couche de protection 430 a pour but de protéger la face supérieure de l'électrode supérieure lors de l'étape ultérieure d'implantation ionique (cf. Fig.4C). Ainsi, elle présente une épaisseur suffisante pour absorber la totalité des ions qui seront dirigés vers la face supérieure de l'électrode.

La figure 4B représente une étape S2 au cours de laquelle la couche conductrice 420 est gravée pour délimiter l'électrode supérieure 440 de la cellule mémoire. La couche conductrice 420 est gravée en forme de mésa dont les flancs sont avantageusement verticaux. La technique de gravure utilisée est de préférence une gravure sèche fortement anisotrope, telle que la gravure plasma RIE (« Reactive ion Etching » en anglais).

La couche de protection 430 sert avantageusement de masque dur lors de la gravure de la couche conductrice 420. Le masque dur est par exemple formé par photolithographie optique ou extrême UV et gravure de la couche de protection 430, puis la couche conductrice 420 est gravée à travers ce masque dur.

Dans le mode de mise en œuvre préférentiel de la figure 4B, la couche conductrice 420 est gravée en laissant intacte la couche d'oxyde 410 sous-jacente. Cela peut être obtenu en choisissant une chimie de gravure sélective par rapport à l'oxyde utilisé. La chimie de gravure dépend des matériaux constituant la couche conductrice 420 et la couche d'oxyde 410. Dans le cas particulier d'une couche conductrice 420 en TiN ou Ti et d'une couche d'oxyde 410 en HfO$_2$, la chimie de gravure utilisée pour graver la couche conductrice 420 sélectivement par rapport à la couche 410 peut être Cl$_2$/HBr.

La couche d'oxyde 410 sert alors de couche d'arrêt de la gravure. Préserver la couche d'oxyde 410 lors de l'étape de gravure S2 permet de protéger l'électrode inférieure 302 de l'étape d'implantation ionique ultérieure (Fig.4C).

À l'inverse, dans une variante de mise en œuvre, la couche d'oxyde 410 est gravée en même temps que la couche conductrice 420.

Enfin, à l'étape S3 de la figure 4C, on procède à une étape d'implantation ionique de façon à créer une zone de défauts localisée sur un bord de la cellule mémoire, c'est-dire, sur un bord de l'empilement électrode inférieure 302 - couche d'oxyde 410 - électrode supérieure 440. Pour ce faire, un des flancs verticaux de l'électrode supérieure 440 (le flanc droit dans l'exemple de la figure) est exposé à un faisceau d'ions 450 oblique. Le faisceau d'ions 450 est incliné par rapport à la perpendiculaire au substrat 300 d'un angle $\alpha$ compris entre 20° et 65°.

Du fait de l'inclinaison du faisceau 450, les ions arrivant au pied du flanc pénètrent dans la couche d'oxyde 410 et génèrent des défauts structurels dans cette couche d'oxyde.

L'effet recherché par la création de cette zone de défauts localisée est le confinement du filament conducteur dans cette même zone, lors du fonctionnement de la cellule mémoire. En effet, comme mentionné dans le brevet US8872268, les défauts structurels générés par l'implantation d'ions métalliques, d'ions oxygène, d'ions halogène négativement chargé (F⁻, CL⁻...), d'ions silicium ou d'ions argon dans la couche d'oxyde favorisent la formation du filament conducteur. Les défauts peuvent être notamment des atomes métalliques, de silicium ou d'oxygène en position interstitielle, des atomes métalliques ou de silicium en position substitutionnelle ou des lacunes d'oxygène. Dans le cas des ions métalliques, il semblerait que les atomes implantés constituent une partie du filament conducteur de la cellule mémoire.

Le filament conducteur se forme pour la première fois lors du processus de « forming » (« formage » en français) de la cellule mémoire. Le « forming » d'une cellule consiste en un claquage réversible de l'oxyde, c'est-à-dire que l'oxyde passe d'un état isolant à un état conducteur. Après ce claquage de l'oxyde, la résistance électrique du matériau actif peut passer d'un état (conducteur) faiblement résistif (LRS) à un état (isolant) fortement résistif (HRS), par des opérations d'effacement et d'écriture. Lors d'un cycle d'effacement et d'écriture, le filament conducteur est rompu puis reconstruit. Par contre, il ne disparaît pas totalement, ni ne change de zone dans la couche d'oxyde située entre les électrodes (il se reconstruit là où il s'est formé initialement, lors de l'étape de « forming »).

Contrairement au procédé selon l'art antérieur, le procédé de fabrication des figures 4A-4C ne requiert aucun masque pour l'étape d'implantation S3. Toute la surface du substrat peut être exposée au faisceau d'ions 450 sous incidence oblique, ce qui simplifie grandement la fabrication de la mémoire OxRAM. La délimitation de la zone de défauts localisée sous l'électrode supérieure résulte, comme cela est décrit ci-après, uniquement d'un effet d'ombrage de l'électrode supérieure.

La figure 5 représente schématiquement l'état de la cellule mémoire immédiatement après l'étape S3 d'implantation ionique.

Une partie supérieure de la couche de protection 430, une partie latérale de la couche de protection 430 et une partie latérale de l'électrode supérieure 440, du côté de l'exposition au faisceau d'ions 450 (ici du côté droit), ont été implantées (toutes ces parties n'ont en fait pas la même épaisseur, car la densité des matériaux varie). La couche de protection 430 empêche que les ions n'atteignent la surface de l'électrode supérieure 440, où la reprise de contact sera réalisée. Ainsi, grâce à la couche de protection 430, la qualité du contact électrique pris sur l'électrode supérieure n'est pas amoindrie par l'implantation d'ions et la formation de défauts structurels dans l'électrode supérieure 440.

Par ailleurs, on peut distinguer deux zones distinctes dans la couche d'oxyde 410 : une première zone 411 implantée par les ions et une deuxième zone 412, adjacente à la première zone 411, mais dépourvue d'ions. La deuxième zone 412 dépourvue d'ions se situe dans l'ombre de l'électrode supérieure 440 par rapport au faisceau d'ions 450. À l'inverse, la première zone 411 implantée correspond aux zones non ombragées de la couche d'oxyde 410. La première zone 411 de la couche d'oxyde s'étend en dehors de l'électrode supérieure 440 (à gauche et à droite de l'électrode) et comprend une portion 413 située sous le bord de l'électrode supérieure 440.

Autrement dit, sous l'électrode supérieure, seule la portion 413 de la couche d'oxyde 410 immédiatement adjacente au flanc exposé de l'électrode supérieure 440 est implantée, alors que la grande majorité de la couche d'oxyde située sous l'électrode supérieure 440 n'est pas impactée par l'implantation ionique.

La forme et les dimensions (largeur et profondeur) de la zone implantée 413 dépendent des paramètres d'implantation (nature de l'ion, dose, angle et énergie). La largeur moyenne de la portion implantée 413 désigne ici la dimension transversale mesurée (en moyenne) parallèlement au plan du substrat 300 et située dans le plan de coupe transversale de la figure 5. La profondeur de la portion implantée 413 est la dimension mesurée perpendiculairement au plan du substrat 300.

Selon l'invention, ces conditions sont choisies de manière à obtenir une largeur moyenne d'implantation du même ordre de grandeur (voire un peu supérieure) que la taille supposée du filament, soit typiquement entre 5 nm et 10 nm. Avantageusement, on choisira un angle $\alpha$ égal à 45° et on modulera l'énergie d'implantation pour jouer sur la largeur d'implantation.

Dans ce mode de mise en œuvre préférentiel (où seule la couche conductrice 420 est gravée, pas la couche d'oxyde 410), l'énergie d'implantation des ions est de préférence choisie (pour un type d'ions donné) de façon à ce que la profondeur moyenne de pénétration des ions se situe à l'intérieur de la couche d'oxyde 410. Ainsi, les ions ne pénètrent quasiment pas dans l'électrode inférieure 302 et ne risquent pas d'altérer son comportement électrique.

Selon l'invention, la dose d'implantation des ions est, quant à elle, comprise entre $10^{13}$ atomes.cm$^{-2}$ et $10^{16}$ atomes.cm$^{-2}$. Une telle dose a pour effet de diminuer la tension de forming de la cellule mémoire. Par exemple, une dose d'ions silicium implantés dans une couche de $HfO_2$ comprise entre $2.10^{15}$ cm$^{-2}$ et $5.10^{15}$ cm$^{-2}$ permet de diminuer la tension de forming de plus d'1 V.

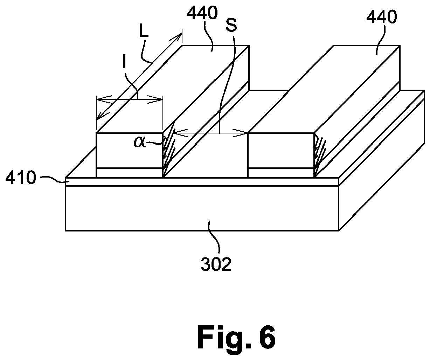

La figure 6 est une vue en perspective de deux cellules mémoire adjacentes formées sur le substrat 300. Les deux cellules mémoire partagent avantageusement la même électrode inférieure 302 (formée par exemple par une ligne) et la même couche d'oxyde 410. Elles ont par contre chacune une électrode supérieure 440 en forme de mésa. Les différentes électrodes supérieures ont de préférence été formées simultanément à partir d'une seule couche conductrice 420, comme décrit précédemment en relation avec la figure 4B. Les différentes cellules ou points mémoire d'une mémoire OxRAM peuvent ainsi être délimitées uniquement par leur électrode supérieure 440.

Les électrodes supérieures 440 ont avantageusement une largeur l comprise entre 80 nm et 300 nm, et une longueur L (dans la direction perpendiculaire) comprise entre 80 nm et 300 nm. Pour atteindre de telles dimensions, les techniques de lithographie avancées, telles que la lithographie à faisceau d'électrons (e-beam), ne sont pas nécessaires.

Les électrodes supérieures 440 de ces deux cellules consécutives dans le plan mémoire sont espacées d'une distance S donnée. L'électrode supérieure d'une cellule mémoire ne doit pas faire obstacle au faisceau d'ions dirigé vers une autre cellule mémoire. Cette condition sur l'angle d'implantation α peut être approximée par la relation suivante :

$$\tan \alpha \leq \frac{S}{h}$$

où h est l'épaisseur de l'électrode supérieure et S est la distance de séparation entre les deux électrodes.

De préférence, le faisceau d'ions est incliné par rapport au flanc exposé de l'électrode d'un angle α compris entre 40° et 50°, par exemple 45°. Cette deuxième plage, plus restreinte, permet d'obtenir simultanément des zones localisées de dimensions du même ordre de grandeur que l'épaisseur de la couche d'oxyde et une densité d'intégration élevée des cellules de la mémoire.

Ainsi, ce procédé de fabrication permet de limiter considérablement la zone de formation du filament conducteur dans la cellule mémoire, appelée également zone active, grâce à une implantation d'ions localisée sous un bord de l'électrode supérieure. À titre d'exemple, la superficie de la zone active d'une cellule mémoire ayant une couche d'oxyde de 5 nm d'épaisseur et implantée selon un angle de 45° est égale à 1000 nm² (L = 200 nm x $l_2$ = 5 nm).

À titre de comparaison, la zone active d'une cellule mémoire mesurant 200 nm de côté et dans laquelle aucune zone de défauts n'est prévue présente une superficie de plus de 40 000 nm², soit au moins 40 fois plus que la cellule mémoire implantée. Pour obtenir la même superficie de zone active avec le procédé de fabrication classique, il faudrait délimiter une électrode supérieure mesurant environ 30 nm de côté, ce qui est complexe et coûteux à obtenir en photolithographie.

Le procédé de fabrication peut également comporter, après l'étape d'implantation ionique S3, une étape d'encapsulation de la cellule mémoire, par exemple avec du nitrure de silicium (SiN) ou du dioxyde de silicium (SiO₂), et une étape de reprise de contact sur la face supérieure de l'électrode supérieure, par exemple au moyen d'un plot d'interconnexion (via) ou d'un niveau d'interconnexion (ligne).

Comme il n'est pas nécessaire de réduire les dimensions de l'électrode supérieure pour obtenir une faible zone active, il y a peu de contraintes pour effectuer la reprise de contact sur l'électrode supérieure. Le procédé de fabrication selon l'invention rend donc plus facile la fin d'intégration de la mémoire.

De nombreuses variantes et modifications du procédé de fabrication décrit ci-dessus apparaîtront à l'homme du métier. En particulier, à l'étape S3 de la figure 4C, le substrat 300 peut être entraîné en rotation lors de d'implantation des ions. Cela a pour effet d'exposer tous les flancs de l'électrode supérieure 440 au faisceau d'ions incliné 450 et, par conséquent, de former des défauts à la périphérie de la cellule mémoire (plutôt que sur un seul bord de la cellule mémoire), c'est-à-dire sur tous les bords de la cellule mémoire. L'étape d'implantation S3 peut être ainsi mise en œuvre plus facilement. La superficie de la zone active sera par contre plus importante.

Enfin, bien que ce ne soit pas nécessaire pour prendre le contact sur l'électrode supérieure, il est également possible de retirer la couche de protection 430 ayant servi de masque de gravure après l'étape d'implantation S3.

**Revendications**

1. Procédé de fabrication d'une mémoire vive résistive comprenant les étapes suivantes :

    - déposer (S1) une couche en un matériau actif de résistance électrique variable (410) sur un substrat (300) contenant une première électrode (302), dite électrode inférieure ;
    - déposer (S1) une couche électriquement conductrice (420) sur la couche de matériau actif ;
    - graver (S2) la couche électriquement conductrice de façon à délimiter une deuxième électrode (440), dite électrode supérieure, en regard de l'électrode inférieure (302) ;
    - exposer (S3) au moins un flanc de l'électrode supérieure (440) à un faisceau d'ions (450) incliné par rapport à la normale au substrat d'un angle (α) compris entre 20° et 65°, de façon à implanter les ions dans une portion (413) de la couche de matériau actif (410) adjacente audit flanc et située sous l'électrode supérieure (440),

    caractérisé en ce que les conditions d'implantation des ions sont choisies de façon à créer des défauts dans la structure du matériau actif et à obtenir une largeur moyenne d'implantation comprise entre 5 nm et 10 nm et en ce que les ions sont implantés à une dose comprise entre $10^{13}$ atomes.cm⁻² et $10^{16}$ atomes.cm⁻².

**2.** Procédé selon la revendication 1, dans lequel le faisceau d'ions (450) est incliné par rapport à la normale au substrat (300) d'un angle (α) compris entre 40° et 50°.

**3.** Procédé selon l'une des revendications 1 et 2, dans lequel la couche de matériau actif (410) sert de couche d'arrêt lors de la gravure de la couche électriquement conductrice (420).

**4.** Procédé selon l'une quelconque des revendications 1 à 3, dans lequel les ions sont implantés avec une énergie telle que la profondeur moyenne de pénétration des ions se situe à l'intérieur de la couche de matériau actif (410).

**5.** Procédé selon l'une quelconque des revendications 1 à 4, comprenant une étape (S1) de dépôt d'un matériau de protection (430) sur la couche électriquement conductrice (420) avant l'étape (S2) de gravure de la couche électriquement conductrice.

**6.** Procédé selon l'une quelconque des revendications 1 à 5, dans lequel les ions implantés sont des ions métalliques, des ions oxygène, des ions halogène, des ions silicium ou des ions argon.

**7.** Procédé selon l'une quelconque des revendications 1 à 6, dans lequel la couche électriquement conductrice (420) est gravée de façon à délimiter au moins deux électrodes supérieures et dans lequel l'angle d'inclinaison α du faisceau d'ions (450) est choisi de telle sorte que

$$\tan \alpha \le \frac{S}{h}$$

S étant la distance minimale séparant deux électrodes et h l'épaisseur de la couche électriquement conductrice.

**8.** Procédé selon l'une quelconque des revendications 1 à 7, dans lequel le matériau actif (410) est un oxyde de métal de transition.

**Patentansprüche**

**1.** Verfahren zur Herstellung eines resistiven Schreib-Lese-Speichers mit den folgenden Schritten:

- Aufbringen (S1) einer Schicht aus einem aktiven Material mit variablem elektrischen Widerstand (410) auf ein Substrat (300), das eine erste Elektrode (302), die sogenannte untere Elektrode, enthält;
- Aufbringen (S1) einer elektrisch leitfähigen Schicht (420) auf die Schicht aus aktivem Material;
- Ätzen (S2) der elektrisch leitfähigen Schicht, um eine zweite Elektrode (440), die so genannte obere Elektrode, gegenüber der unteren Elektrode (302) abzugrenzen;
- Aussetzen (S3) mindestens einer Flanke der oberen Elektrode (440) einem Ionenstrahl (450), der gegenüber der Normalen des Substrats um einen Winkel (α) zwischen 20° und 65° geneigt ist, um die Ionen in einen Abschnitt (413) der Schicht aus aktivem Material (410) zu implantieren, der an die Flanke angrenzt und sich unter der oberen Elektrode (440) befindet,

**dadurch gekennzeichnet, dass** die Bedingungen für die Implantation der Ionen so gewählt werden, dass in der Struktur des aktiven Materials Defekte erzeugt werden und eine mittlere Implantationsbreite zwischen 5 nm und 10 nm erzielt wird, und dass die Ionen in einer Menge zwischen $10^{13}$ Atomen.cm$^{(-2)}$ und $10^{16}$ Atomen.cm$^{(-2)}$ implantiert werden.

**2.** Verfahren nach Anspruch 1, bei dem der Ionenstrahl (450) gegenüber der Normalen zum Substrat (300) um einen Winkel (α) zwischen 40° und 50° geneigt ist.

**3.** Verfahren nach einem der Ansprüche 1 oder 2, bei dem die Schicht aus aktivem Material (410) beim Ätzen der elektrisch leitfähigen Schicht (420) als Stoppschicht dient.

**4.** Verfahren nach einem der Ansprüche 1 bis 3, bei dem die Ionen mit einer solchen Energie implantiert werden, dass die mittlere Eindringtiefe der Ionen innerhalb der Schicht aus aktivem Material (410) liegt.

**5.** Verfahren nach einem der Ansprüche 1 bis 4, einen Schritt (S1) des Aufbringens eines Schutzmaterials (430) auf die elektrisch leitfähige Schicht (420) umfassend vor dem Schritt (S2) des Ätzens der elektrisch leitfähigen Schicht.

**6.** Verfahren nach einem der Ansprüche 1 bis 5, bei dem die implantierten Ionen Metallionen, Sauerstoffionen, Halogenionen, Siliciumionen oder Argonionen sind.

**7.** Verfahren nach einem der Ansprüche 1 bis 6, bei dem die elektrisch leitfähige Schicht (420) so geätzt wird, dass sie mindestens zwei obere Elektroden begrenzt, und bei dem der Neigungswinkel cc des Ionenstrahls (450) so gewählt wird, dass

$$\tan\alpha \leq \frac{S}{h}$$

wobei S der Mindestabstand zwischen zwei Elektroden und h die Dicke der elektrisch leitfähigen Schicht ist.

**8.** Verfahren nach einem der Ansprüche 1 bis 7, bei dem das aktive Material (410) ein Übergangsmetalloxid ist.

**Claims**

**1.** Process for manufacturing a resistive random access memory including the following steps:

- depositing (S1) a layer made of an active material of variable electrical resistance (410) on a substrate (300) containing a first electrode (302), designated lower electrode;
- depositing (S1) an electrically conductive layer (420) on the layer of active material;
- etching (S2) the electrically conductive layer so as to delimit a second electrode (440), designated upper electrode, facing the lower electrode (302);
- exposing (S3) at least one flank of the upper electrode (440) to an ion beam (450) inclined with respect to the normal to the substrate by an angle (α) comprised between 20° and 65°, so as to implant the ions in a portion (413) of the layer of active material (410) adjacent to said flank and situated under the upper electrode (440),

**characterized in that** the ion implantation conditions are chosen so as to create defects in the structure of the active material and to obtain an average implantation width comprised between 5 nm and 10 nm and **in that** the ions are implanted at a dose comprised between $10^{13}$ atoms.cm$^{-2}$ and $10^{16}$ atoms.cm$^{-2}$.

**2.** Process according to claim 1, wherein the ion beam (450) is inclined with respect to the normal to the substrate (300) by an angle (α) comprised between 40° and 50°.

**3.** Process according to one of claims 1 and 2, wherein the layer of active material (410) serves as stop layer during the etching of the electrically conductive layer (420).

**4.** Process according to any of claims 1 to 3, wherein the ions are implanted with an energy such that the average penetration depth of the ions is situated within the layer of active material (410).

**5.** Process according to any of claims 1 to 4, including a step (S1) of depositing a protective material (430) on the electrically conductive layer (420) before the step (S2) of etching the electrically conductive layer.

**6.** Process according to any of claims 1 to 5, wherein the implanted ions are metal ions, oxygen ions, halogen ions, silicon ions or argon ions.

**7.** Process according to any of claims 1 to 6, wherein the electrically conductive layer (420) is etched so as to delimit at least two upper electrodes and wherein the angle of inclination α of the ion beam (450) is chosen such that

$$\tan\alpha \leq \frac{S}{h}$$

S being the minimum distance separating two electrodes and h the thickness of the electrically conductive layer.

**8.** Process according to any of claims 1 to 7, wherein the active material (410) is a transition metal oxide.

120

130

100

110

**Fig. 1A**

10

150

120

130

140

100

110

10'

**Fig. 1B**

220

210

200

100

110

230            230

(Art antérieur)

**Fig. 2**

300

302            301

**Fig. 3**

430

420 { 422
421

-S1-  410

300

301                    302

**Fig. 4A**

430

-S2-                                           440

420 { 422
421

410

302

**Fig. 4B**

450                    α        450

-S3-                                           440

410

300

**Fig. 4C**

440

430                    412        411

410

413

300                    302

**Fig. 5**

**Fig. 6**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8872268 B, Miller

- US 2015041750 A

**Littérature non-brevet citée dans la description**

- **RYOO KYUNG-CHANG et al.** Conductive Filament Control in Highly Scalable Unipolar Resistive Switching Devices for Low-Power and High-density Next Generation Memory. *IEDM*, 2013